Europäisches Patentamt

European Patent Office

Office européen des brevets

(19)

(11) **EP 0 890 113 B1**

(12) **EUROPÄISCHE PATENTSCHRIFT**

(45) Veröffentlichungstag und Bekanntmachung des Hinweises auf die Patenterteilung:
**06.10.1999 Patentblatt 1999/40**

(51) Int Cl.$^6$: **G01R 33/035**

(86) Internationale Anmeldenummer:
**PCT/DE97/00552**

(21) Anmeldenummer: **97918034.6**

(22) Anmeldetag: **18.03.1997**

(87) Internationale Veröffentlichungsnummer:
**WO 97/36186 (02.10.1997 Gazette 1997/42)**

(54) **ANORDNUNG ZUR ANKOPPLUNG EINES HF-SQUID-MAGNETOMETERS AN EINEN SUPRALEITENDEN TANKSCHWINGKREIS**

ARRANGEMENT FOR COUPLING AN RF-SQUID MAGNETOMETER TO A SUPERCONDUCTIVE TANK CIRCUIT

DISPOSITIF DE COUPLAGE D'UN MAGNETOMETRE HF A ANNEAU DE COMMUTATION A UN CIRCUIT BOUCHON SUPRACONDUCTEUR

(84) Benannte Vertragsstaaten:
**DE FR GB IT**

(30) Priorität: **26.03.1996 DE 19611900**
**28.11.1996 DE 29620718 U**

(43) Veröffentlichungstag der Anmeldung:
**13.01.1999 Patentblatt 1999/02**

(73) Patentinhaber: **FORSCHUNGSZENTRUM JÜLICH GMBH**
**52425 Jülich (DE)**

(72) Erfinder:
• **ZHANG, Yi**
**D-52428 Jülich (DE)**
• **SCHUBERT, Jürgen**
**D-50189 Elsdorf (DE)**
• **ZANDER, Willi**
**D-52457 Aldenhoven (DE)**
• **SOLTNER, Helmut**
**D-52459 Inden (DE)**
• **BANZET, Marko**
**D-52428 Jülich (DE)**

(56) Entgegenhaltungen:
EP-A- 0 441 281            DE-C- 4 436 448
US-A- 5 326 986

• ZHANG Y ET AL: "HIGH-SENSITIVITY MICROWAVE RF SQUID OPERATING AT 77 K" SUPERCONDUCTOR SCIENCE AND TECHNOLOGY, Bd. 7, Nr. 5, 1.Mai 1994, Seiten 269-272, XP000442664
• SUN J Z ET AL: "DIRECT-COUPLED HIGH-TC THIN FILM SQUIDS USING STEP-EDGE WEAK-LINK JUNCTIONS" APPLIED SUPERCONDUCTIVITY, Bd. 3, Nr. 7/10, 1.Juli 1995, Seiten 425-441, XP000585002
• LUDWIG F ET AL: "MULTILAYER MAGNETOMETERS BASED ON HIGH-TC SQUIDS" APPLIED SUPERCONDUCTIVITY, Bd. 3, Nr. 7/10, 1.Juli 1995, Seiten 383-398, XP000585001
• Y. ZHANG ET AL.: "HTS RF SQUIDS with Fully Integrated Planar Tank Circuits" IEEE TRANSACTIONS ON APPLIED SUPERCONDUCTIVITY, Bd. 7, Nr. 2, Mai 1997, Seiten 287-2873, XP002042209

**Beschreibung**

Die vorliegende Erfindung betrifft eine Anordnung zur Ankopplung eines rf-SQUID-Magnetometers an einen supraleitenden Tankschwingkreis.

Verschiedene Vorschläge sind bisher verfolgt worden, rf-SQUID-Magnetometer an supraleitende Tankschwingkreise anzukoppeln.

Aus "Zhang Y et al: "High-sensitivity mcrowave RF SQUID operatin at 77K" SUPERCONDUCTOR SCIENCE AND TECHNOLOGY, Bd. 7; Nr. 5, 1. Mai 1994, Seiten 269-272, XP000442664" ist bekannt, einen $\lambda$-Resonator cder $\lambda/2$-Resonator zu verwenden, an den ein rf-SQUID galvanisch angekoppelt ist und der gleichzeitig als ein Fluß-Pickup-Loop funktioniert. Ein solcher SQUID-Magnetometer kann eine Tankfrequenz von 3 GHz haben.

Der Einsatz eines $\lambda$-Resonators ist allerdings problematisch, da dieser nur eine geringe Güte von einigen 100 zeigt. Die stellt in Anbetracht der schon mit den $\lambda/2$-Resonatoren erreichten Guten von einigen 1000 eine recht geringe Größe dar. Darüber hinaus führt auch die Tatsache, daß durch die galvanische Kopplung ein schwer zu kalkulierender Parameter, nämlich die Hochfrequenzstromverteilung, mit berücksichtigt werden muß, zu beträchtlichen Problemen. Die Hochfrequenzstromverteilung stellt eine nicht einfach zu berechnende oder experimentell zu kontrollierende Größe dar. Das SQUID-Layout ist daher schwer zu optimieren.

Aus DE-C-44 36 448 ist bekannt, planare LC-Schwingkreise aus YBacuo-Dunnschichten mit hoher Frequenz und hcher Güte herzustellen. Diese LC-Schwingkreise werden in einer flip-chip-Anordnung mit dem rf-SQUID in washer-SQUID-Struktur betrieben. Die dabei auftretenden parasitären Kapazitäten zwischen dem LC-Schwingkreis und dem rf-SQUID verringern die Güte des LC-Schwingkreises und machen die Stromverteilung in der kombinierten Lc-Schwingkreis -/ washer-SQUID-Struktur kompliziert.

Die Aufgabe der vorliegenden Erfindung ist daher, eine Anordnung zu schaffen, die beim Ankoppeln eines rf-SQUID-Magnetometers an einen supraleitenden Schwingkreis die oben stehenden Probleme beseitigt.

Die Aufgabe wird dadurch gelöst, daß der Tankschwingkreis und das rf-SQUID-Magnetometer auf dem gleichen Substrat planar zueinander untergebracht sind, wobei der Tankschwingkreis eine Schwingkreisspule und eine flächige kapazitive Struktur aufweist, die das rf-SQUID-Magnetometer umschließen.

Die erfindungsgemäße Anordnung bezieht sich auf die Möglichkeit einer vorteilhaften, optimalen Ankopplung von einem rf-SQUID-Magnetometer mit einem Tankschwingkreis, die die eingangs genannten Nachteile nicht aufweist. Mit der vollintegrierten Anordnung von SQUID-Magnetometer und Tankschwingkreis wird die Güte des Schwingkreises -im Gegensatz zu der oben genannten flip chip Lösung des Standes der Technik- sogar um den Faktor 2 bis 3 erhöht, z. B. auf eine Güte von Q=6000 bei einer Resonanzfrequenz von $f_o$=580 MHz. Ein Grund dafür ist, daß in der erfindungsgemäßen Anordnung squidbedingt die Abstrahlung der Hochfrequenz verringert wird.

Zudem ermöglicht die vollintegrierte Anordnung eine einfache Abschätzung der Kopplung k zwischen dem rf-SQUID und dem Tankschwingkreis.

Gemäß Anspruch 2 ist es von Vorteil, wenn der Tankschwingkreis aus supraleitendem Dünnschichtmaterial besteht. Dadurch werden die Eigenschaften der erfindungsgemäßen Anordnung optimiert.

Weitere Vorteile ergeben sich aus den Merkmalen der Ansprüche 3 bis 13.

Besonders vorteilhaft ist es demnach gemäß Anspruch 10, daß die Schwingkreisspule des Tankschwingkreises als innere Schleife ausgebildet ist, die das rf-SQUID-Magnetometer umschließt und einen Schlitz aufweist. Es ist ebenfalls besonders vorteilhaft gemäß Anspruch 11, wenn auch die Grundplatte als äußere Schleife mit Schlitz und koplanar zu dem rf-SQUID-Magnetometer und dem Tankschwingkreis ausgebildet ist, da dadurch ein durch die Grundplatte bedingtes Rauschen unterdrückt werden kann.

Es ist zudem besonders vorteilhaft, daß gemäß Anspruch 12 Orientierung der Schlitze der inneren und der äußeren Schleife zueinander die Resonanzfrequenz bestimmt. Dadurch kann in kostengünstiger Weise ein Mehrkanal-HTSL-SQUID-System z. B. für medizinische Anwendungen hergestellt werden.

Ausführungsformen der vorliegenden Erfindung werden im folgenden anhand der Zeichnungen näher beschrieben. Es zeigen:

Fig. 1      eine schematische Draufsicht eines rf-SQUID und eines Tankschwingkreises in der erfindungsgemäßen Anordnung;

Fig. 2      eine schematische, perspektivische Ansicht eines bulk-rf-SQUID mit innenliegendem Tankschwingkreis gemäß einer Anordnung des Standes der Technik;

Fig. 3      eine schematische Draufsicht des bulk-rf-SQUID aus Fig.2;

Fig. 4      eine schematische Draufsicht einer weiteren Ausführungsform des rf-SQUID aus Fig. 1 mit weiteren Abmessungsangaben;

Fig. 5a    eine schematische Draufsicht einer weiteren Ausfühzrungsform mit multiloop-SQUID-Struktur;

Fig. 5b    eine schematische Draufsicht einer weiteren Ausführungsform mit Strominjektion-SQUID-Struktur;

Fig. 5c    eine schematische Draufsicht einer weiteren Ausführungsform mit einlagigem Transformator;

Fig. 5d    eine schematische Draufsicht einer weiteren Ausführungsform mit mehrlagigem Transformator mit mehreren Windungen;

Fig. 5e    eine schematische Draufsicht einer weiteren Ausführungsform mit Doppelspulen-Gradiometer;

Fig. 6    eine Prinzipdarstellung eines rf-SQUID mit einem planaren Tankschwingkreis und einer Grundplatte gemäß den vorstehenden Ausführungsformen;

Fig. 7a    eine schematische Ansicht einer ersten Geometrie eines SQUID-Magnetometers mit einer als koplanare Schleife ausgebildeten Grundplatte;

Fig. 7b    eine schematische Ansicht einer zweiten Geometrie eines SQUID-Magnetometers mit einer als koplanare Schleife ausgebildeten Grundplatte;

Fig. 7c    eine schematische Ansicht einer dritten Geometrie eines SQUID-Magnetometers mit einer als koplanare Schleife ausgebildeten Grundplatte;

Fig. 8    ein Diagramm einer Testmessung mit einer Geometrie gemäß Fig. 7a.

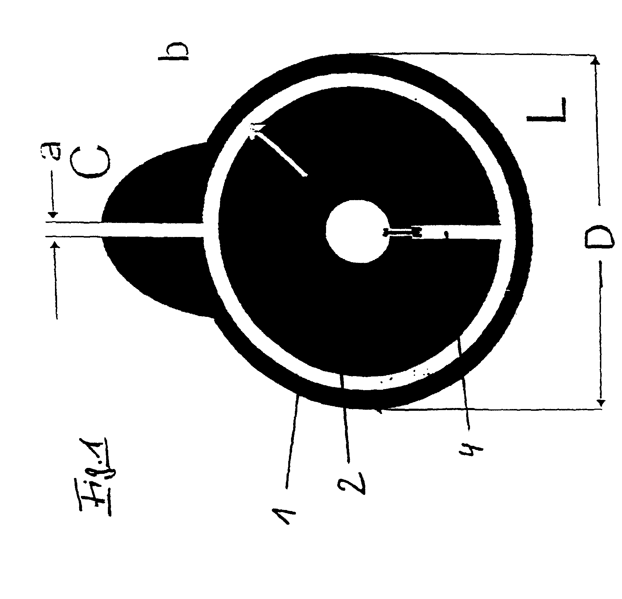

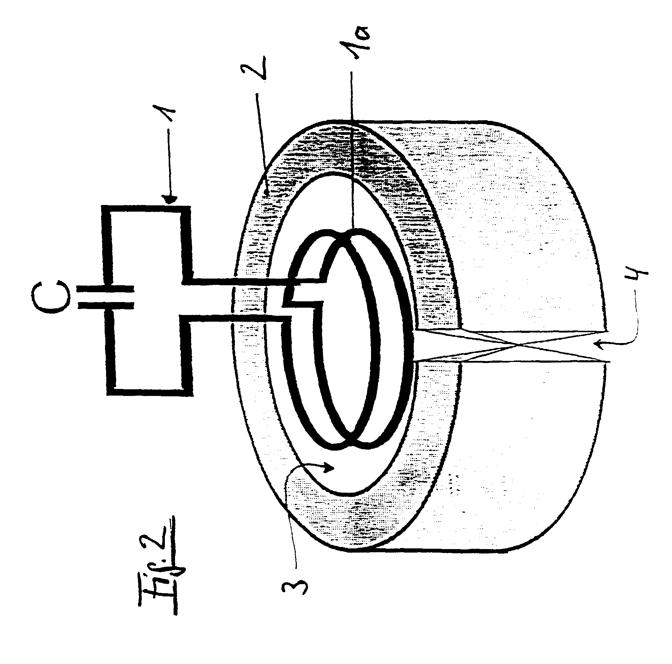

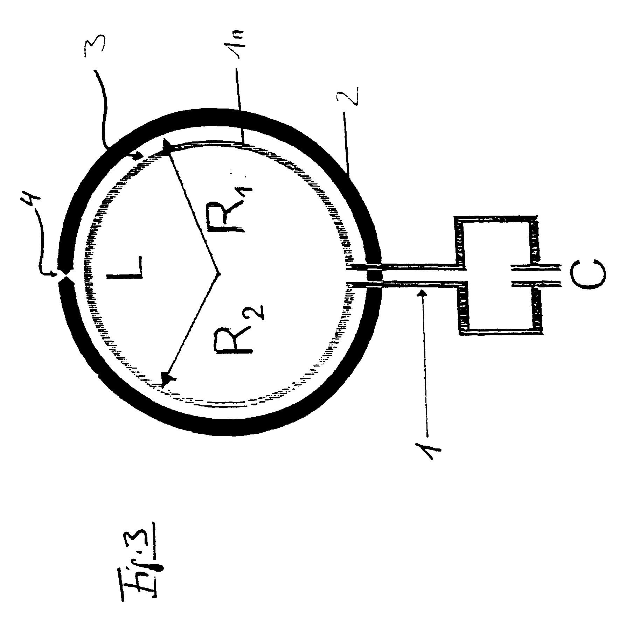

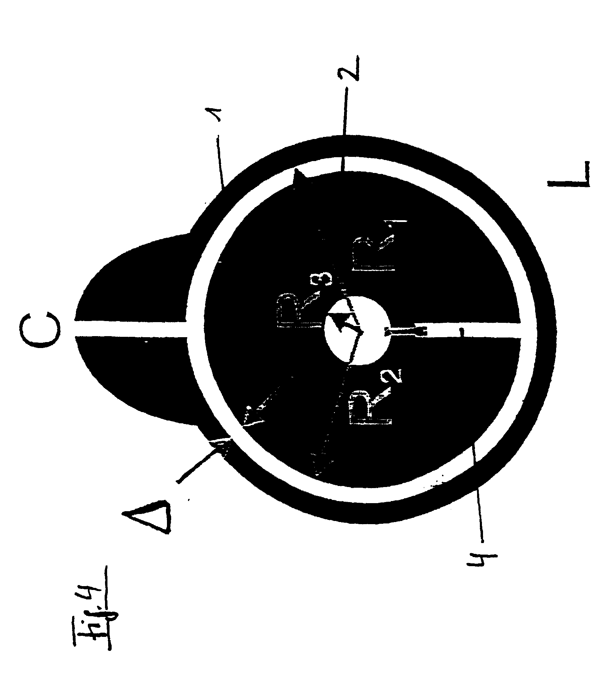

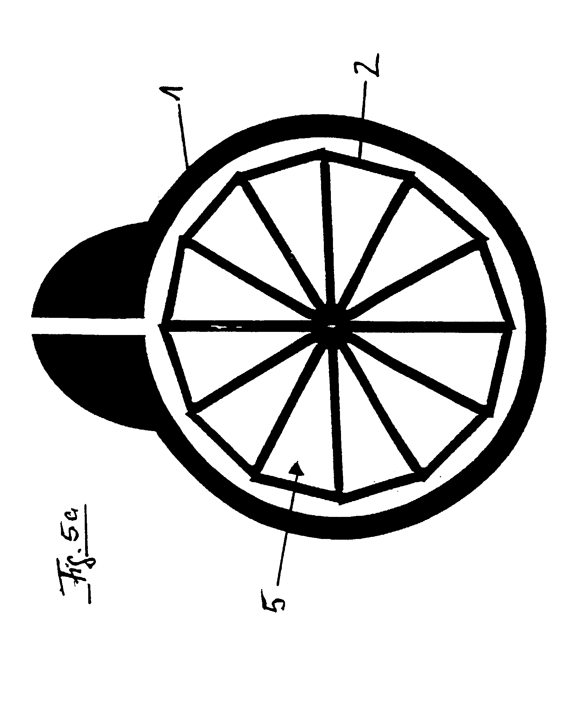

Fig. 1 zeigt einen schematischen Entwurf für eine erfindungsgemäße integrierende Anordnung eines Tankschwingkreises 1 mit einem rf-SQUID 2. Tabelle 1 zeigt die Meßergebnisse bezüglich der Schwingkreisparameter mit bzw. ohne integrierter rf-SQUID-Struktur. Die Messungen beziehen sich, falls nicht anders angegeben auf a = 0.2 mm, b = 0.5 mm, D = 22 mm, $\Delta$ = 0.15 mm, s= 0.1 mm.

Aus der Tabelle 1 erkennt man, daß die charakteristischen Parameter des Tankschwingkreises 1 im wesentlichen durch den äußeren Durchmesser D, in geringerem Maße auch durch den Abstand b des Kondensators C, bestimmt sind. Bei Verringerung der Breite L vergrößert sich die Induktivität.

Tabelle 1

|  | 1 | 2 | 3 | 4 | 5 | 6 |
|---|---|---|---|---|---|---|
| $f_o$ MHz | / 480 | 511.2 | 500 | 550 | 520 | 800 |
| $Q_o$ | 2400 | 5900 | 6300 | 5500 | 4000 | 3500 |

Für die Messungen 1 bis 6 gelten folgende Bedingungen:

1) $f_o$ = 480, $Q_o$ = 2400
2) Vollkreis ohne SQUID-Struktur
3) mit SQUID-Struktur
4) a = 0.4 mm
5) b = 0.2 mm
6) D = 15 mm

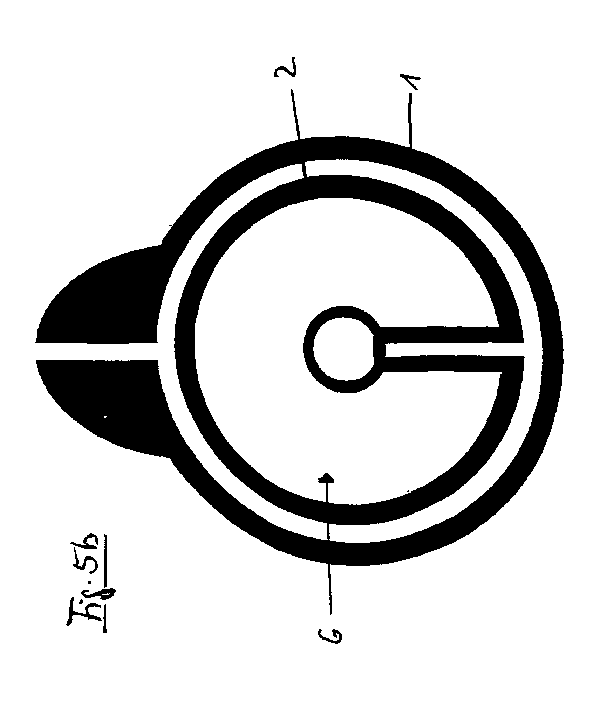

Zur einfachen Analyse der Kopplung zwischen rf-SQUID 2 und Tankschwingkreis 1 wird die Arbeitsanordnung für eine bulk-rf-SQUID untersucht (Fig. 2). Durch mechanische Bearbeitung zum Beispiel eines supraleitenden bulk-Zylinders wird eine Schwachstelle (weak link) ausgebildet. Zusammen mit dem Rest des Zylinders entsteht dadurch ein rf-SQUID 2 mit einem SQUID-loop 3, welcher mit Hilfe einer gewickelten Tank-Kreisspule 1a, die in den SQUID-Loop eingesetzt ist, angeregt wird. Das Material der Tankkreisspule 1 besteht üblicherweise aus Kupfer.

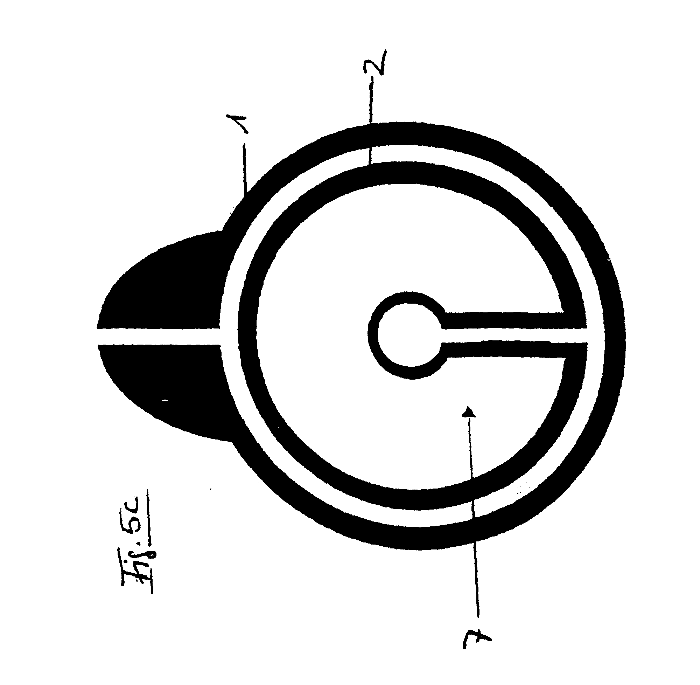

Mit dieser Anordnung läßt sich die Kopplung $k^2$ in einfacher Weise abschätzen. Sie ist gegeben durch $k^2 = S_c/S_L$, wobei $S_c$ die Fläche der Tankkreisspule 1 (=$\pi \bullet R_2^2$) bezeichnet und $S_L$ (= $\pi \bullet R_2^2$) die Fläche des SQUID-loops 3 angibt (siehe Fig. 3). (Praktisch wird aber $k^2 < S_c/S_L$, weil die Länge der Tankkreisspule 1 einen endlichen Wert besitzt, und ein Schlitz 4 des SQUIDs 1 eine von Null verschiedene Breite hat.)

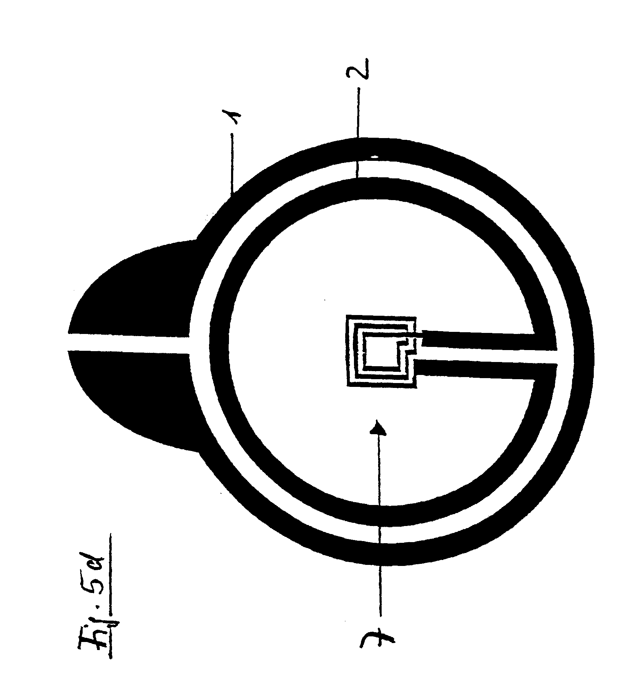

In der Draufsicht (Fig. 3) sieht die Anordnung des bulk-rf-SQUIDs 2 ähnlich aus wie die des erfindungsgemäßen Entwurfs aus Fig. 1. Die Anordnung aus Fig. 1 unterscheidet sich vcn der aus Fig. 2 bzw. Fig. 3 dadurch, daß die Tankkreisspule la den rf-SQUID 2 umschließt (siehe auch Fig. 4). Durch eine geometrische Betrachtung ergibt sich für die Kopplung der Wert $k^2$, der sich aus dem Verhältnis der effektiven Flächen $S_e$ der SQUID-loop 3 und der Fläche $S_c$ der Tankkreispule 1a ergibt.

$$k^2 = S_e/S_c \approx \alpha \bullet R_2 \bullet R_3/(\pi \bullet R_1^2) \approx \alpha \bullet R_3/R_1$$

Die *letzte* Abschätzung gilt wegen $R_1 \approx R_2$. Hierbei liegt der Wert von $\alpha$ zwischen 0.5 und 1.

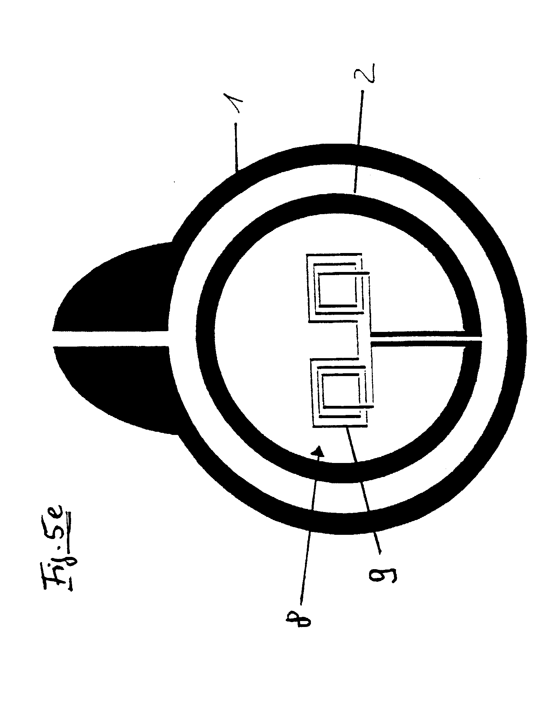

Die erfindungsgemäße integrierte Anordnung gibt die Möglichkeit, viele verschiedene SQUID-Strukturen einzusetzen. Hierunter fallen die schon beschriebenen washer-SQUID-Strukturen und multiloop-Strukturen 5 nach *Drung* (Fig. 5a). Außerdem lassen sich Strominjektions-SQUID-Strukuren 6 in Einlagentechnik realisieren (Fig. 5b). In flip-chip-Technik gibb es die Möglichkeit, einlagige (Fig. 5c) oder mehrlagige Transformatoren 7 mit mehreren Windungen statt der washer-Struktur einzusetzen (Fig. 5d).

Eine *weitere* Möglichkeit wird durch den Gebrauch mit einem Doppelspulen-Gradiometer 8 in flip-chip Technik gegeben. Dabei verringert sich die SQUID-Induktivität um den Faktor 2. Hierbei wird eine Anordnung mit zwei in Serie geschalteten gegensinnigen Spulen 9 verwendet (Fig. 5e). Dabei wird der Kopplungsfaktor zwischen Doppelspule 9 und Doppelspulengradiometer vergrößert. Auf diese Weise entsteht ein hochempfindliches Magnetometer.

Der kapazitive Bereich des Schwingkreises 1 wird ebenfalls kapazitiv an eine 50 Ohm-Leitung (nicht dargestellt) zur Elektronik, die sich auf Raumtemperatur befindet, angekoppelt.

Die ersten Untersuchungen mit einem rf-SQUID 2 mit einem 6.6 mm$^2$ washer und einem 20 µm•20 µm loop in flip-chip-Technik auf einem einlagigen FluBtrafo wurden erfolgreich durchgeführt. Die Kopplung läßt sich in diesem Fall abschätzen mit $\alpha = 0.5$ und $R_3 = 10$ µm und $R_1 = 10$ mm zu $k^2 = 1/2000$. Um die Bedingung $k^2 \bullet Q$ zu erfüllen soll der Wert für die Güte des Schwingkreises mehr als 2000 betragen. Es wurde ein komplettes SQUID-Signal beobachtet. Dies unterstützt die Richtigkeit unserer obigen Abschätzung von $k^2$. Das weiße Fluß-Rauschen $S\Phi^{1/2}$ wurde zu kleiner als $7 \bullet 10^{-6}$ $\Phi_o/\sqrt{Hz}$ bei 77 K bestimmt. Die Eigenschaften des Schwingkreises können aus Tabelle 1 entnommen werden. Es läßt sich $k^2 \bullet Q > 1$ ermitteln.

rf-SQUID-Magnetometer 2 mit Planarschwingkreisen und $\lambda/2$-oder $\lambda$-Resonatoren benötigen eine Grundplatte 10 aus Metall oder Supraleitermaterial. Das hat zur Folge, daß der Tankschwingkreis 1 mit integriertem SQUID 2 und die Grundplatte 10 nicht in einer Ebene angeordnet werden können.

Außerdem stellt die Grundplatte 10 eine mögliche Rauschquelle dar, die den Einsatz eines rf-SQUID-Magnetometers 2 einschränken kann.

In der vorliegenden Erfindung wird diese Schwierigkeit gelost, indem folgende Punkte realisiert werden:

1. Die Grundplatte 10 wird durch eine koplanare Anordnung in Form einer äußeren Schleife 10a ersetzt, wodurch Tankschwingkreis 1, SQUID 2 und Grundplatte 10 in einer Ebene angeordnet werden können.

2. Durch eine einfache Änderung in der Geometrie des koplanaren Schwingkreises 10a wird eine Frequenzänderung der Tankfrequenz des rf-SQUID 2 erzielt. Dies ist ein wesentlicher Vorteil gegenüber dem bisherigen Stand der Technik speziell im Hinblick auf den Aufbau eines Mehrkanal-SQUID-Systems für zum Beispiel medizinische Anwendungen.

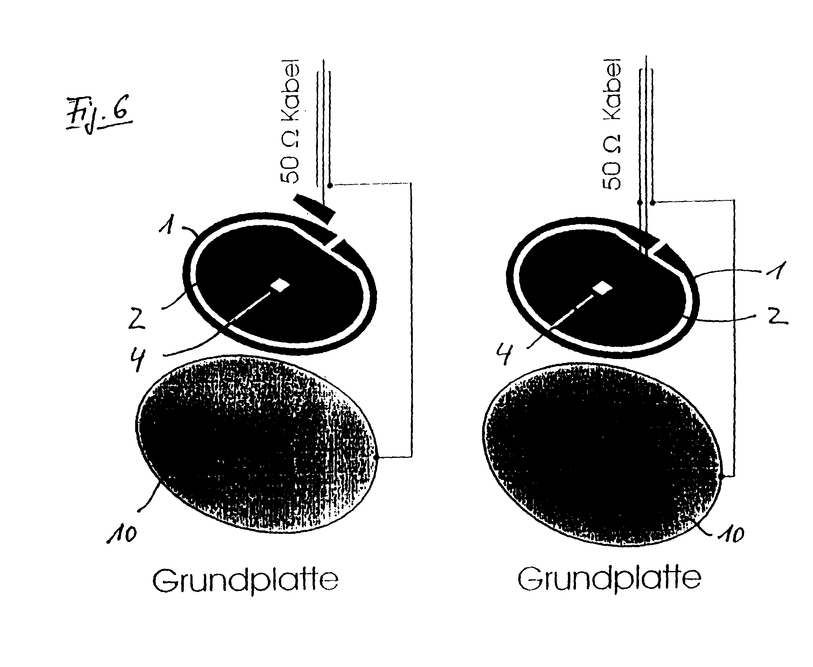

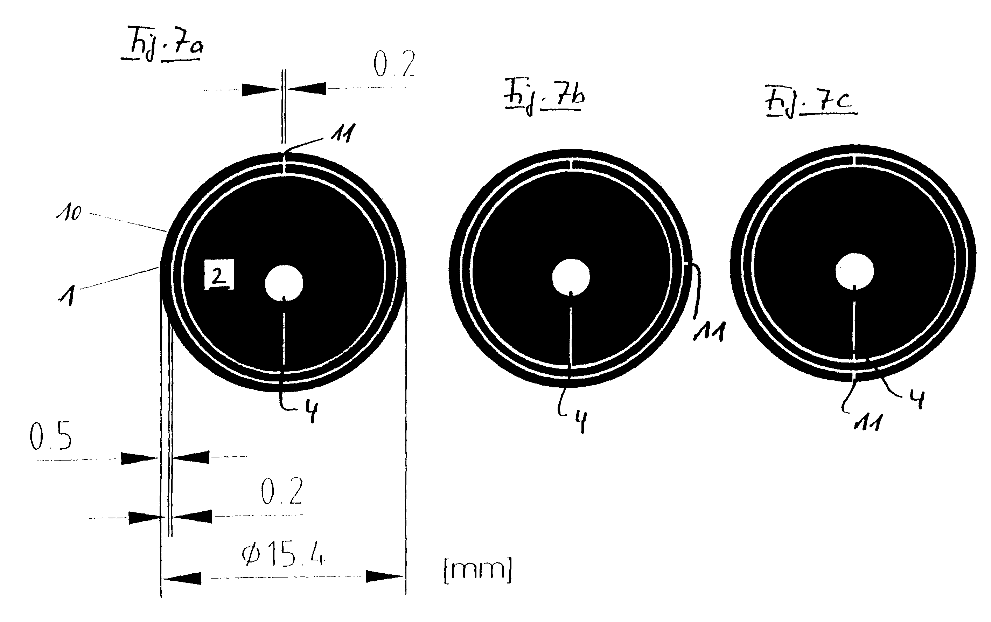

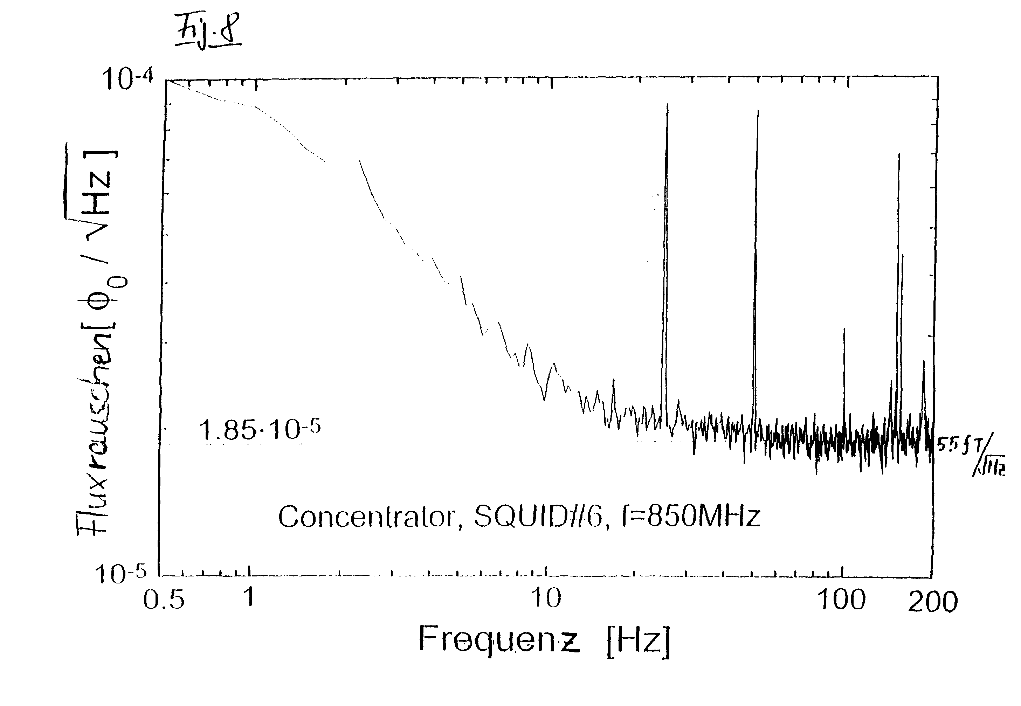

In Figur 6 ist eine Prinzipdarsteilung eines rf-SQUID 2 mit einem planaren Tankschwingkreis 1 und einer Grundplatte 10 dargestellt. In Figur 7a, 7b und 7c ist jeweils eine unterschiedliche Geometrie eines SQUID-Magnetometers 2 dargestellt, die in der Anordnung mit koplanarer äußerer Schleife 10a als rf-Schwingkreis vorliegt. Der SQUID-Geometrie in Figur 6 ist eine weitere außenliegende supraleitende Schleife 10a hinzugefügt. Diese Schleife 10a stellt mit einem Schlitz 11 den koplanaren Schwingkreis dar. Die Fläche A in Figur 2a kann als washer-, Multiloop- oder Strominjektion-SQUID-Struktur ausgelegt sein. Weiterhin besteht die Möglichkeit, diese Fläche als Flußkonzentrator oder Flußtransformator zu verwenden, um den koplanaren Schwingkreis mit einem washer-SQUID-Magnetometer in flip-chip Geometrie zu kombinieren. Testmessungen mit diesem Layout ergaben bei einer Resonanzfrequenz des Tankschwingkreises von 850 MHz eine Güte von ca. 5000 und ein weißes Rauschen von $1.85*10^{-5}\Phi_o/\sqrt{Hz}$ (Fig. 8).

Ein großer Vorteil dieser koplanaren Schwingkreise 10a ist die geometrieabhängige Resonanzfrequenz des Schwingkreises. In den Figuren 7a bis 7c sind drei verschiedene Geometrien dargestellt. Der einzige Unterschied in diesen drei Darstellungen ist die Orientierung des Schlitzes 11 in der äußeren Schleife zu dem Schlitz 4 in der inneren Schleife. In Fig. 7a sind beide Schlitze 4, 11 übereinander ausgerichtet, der Orientierungsunterschied beträgt 0 Grad. Die Resonanzfrequenz liegt bei $f_r = 850$ MHz. Ändert man die Orientierung auf 180 Grad, so nimmt die Resonanzfre-

quenz auf $f_r$=550 MHz ab. Bei 90 Grad beträgt die Resonanzfrequenz $f_r$=650 MHz. Hierdurch ergibt sich eine sehr einfache Möglichkeit, diskrete Frequenzbereiche innerhalb einer Spanne von 300 MHz durch einfache Änderung der Geometrie zu erreichen. Diese diskreten Frequenzen sind für die Realisierung eines Mehrkanal-HTSL-Squid-Systems eine notwendige Voraussetzung.

**Patentansprüche**

1. Anordnung zur Ankopplung eines rf-SQUID-Magnetometers (2) an einen supraleitenden Tankschwingkreis (1), **dadurch gekennzeichnet,** daß der Tankschwingkreis (1) und das rf-SQUID-Magnetometer (2) auf den gleichen Substrat planar zueinander untergebracht sind, wobei der Tankschwingkreis (1) eine Schwingkreisspule (1a) und eine flächige kapazitive Struktur aufweist, die den rf-SQUID-Magnetometer (2) umschließen.

2. Anordnung nach Anspruch 1, **dadurch gekennzeichnet,** daß der Tankschwingkreis (1) aus supraleitendem Dünnschicht-Material besteht.

3. Anordnung nach Anspruch 1 oder 2, **dadurch gekennzeichnet,** daß das rf-SQUID-Magnetometer (2) einen rf-SQUID mit washer beinhaltet.

4. Anordnung nach einem der Ansprüche 1-3, **dadurch gekennzeichnet**, daß das rf-SQUID-Magnetometer (2) einen rf-SQUID mit multiloop-Struktur aufweist.

5. Anordnung nach einem der Ansprüche 1-3, **dadurch gekennzeichnet**, daß das rf-SQUID-Magnetometer (2) einen rf-SQUID mit Strominjektionsstruktur (6) beinhaltet.

6. Anordnung nach einem der Ansprüche 1-3, **dadurch gekennzeichnet,** daß das rf-SQUID-Magnetometer (2) einen rf-SQUID mit einlagiger oder mehrlagiger, mehrwindiger Transformatorstruktur (7) beinhaltet.

7. Anordnung nach einem der Ansprüche 1-3, **dadurch gekennzeichnet,** daß das rf-SQUID-Magnetometer (2) einen rf-SQUID mit Doppellochgradiometerstruktur mit gegensinnigen Spulen (9) aufweist.

8. Anordnung nach einem der vorstehenden Ansprüche, **dadurch gekennzeichnet,** daß der Schwingkreis (1) eine minimale Resonanzfrequenz von 400 MHz und eine minimale Güte von 1000 aufweist.

9. Anordnung nach einem der Ansprüche 1 bis 8, **dadurch gekennzeichnet,** daß das rf-SQUID-Magnetometer (2) an eine Grundplatte (10) angekoppelt ist.

10. Anordnung nach Anspruch 9, **dadurch gekennzeichnet,** daß die Schwingkreisspule (1a) als innere Schleife ausgebildet ist, die das rf-SQUID-Magnetometer (2) umschließt und einen Schlitz (4) aufweist.

11. Anordnung nach Anspruch 9 oder 10, **dadurch gekennzeichnet,** daß die Grundplatte (10) als äußere Schleife (10a) koplanar zu dem rf-SQUID-Magnetometer (2) und dem Tankschwingkreis (1) ausgebildet ist und einen Schlitz (11) aufweist.

**12.** Anordnung nach Anspruch 11,
**dadurch gekennzeichnet,**
daß die Orientierung der Schlitze (4; 11) der inneren Schleife (1a) und der äußeren Schleife (11) zueinander die Resonanzfrequenz $f_r$ bestimmt.

**13.** Anordnung nach Anspruch 12,
**dadurch gekennzeichnet,**
daß eine Verstellung der Schlitze (4; 11) eine Anderung der Resonanzfrequenz $f_r$ von < = 300 MHz bewirkt.

## Claims

**1.** An arrangement for coupling an rf-SQUID magnetometer to a superconducting oscillating tank circuit, characterised in that the oscillating tank circuit (1) and the rf-SQUID magnetometer (2) are accommodated on the same substrate in a planar arrangement to each other, with the oscillating tank circuit (1) comprising an oscillating circuit coil (1a) and an area-capacitive structure which encompass the rf-SQUID magnetometer (2).

**2.** An arrangement according to claim 1, characterised in that the oscillating tank circuit (1) comprises superconducting thin-film material.

**3.** An arrangement according to claim 1 or 2, characterised in that the rf-SQUID magnetometer (2) comprises an rf-SQUID with washer.

**4.** An arrangement according to one of claims 1-3, characterised in that the rf-SQUID magnetometer (2) comprises an rf-SQUID with multiloop structure.

**5.** An arrangement according to one of claims 1-3, characterised in that the rf-SQUID magnetometer (2) comprises an rf-SQUID with current injection structure (6).

**6.** An arrangement according to one of claims 1-3, characterised in that the rf-SQUID magnetometer (2) comprises an rf-SQUID with single-layer or multi-layer multiturn transformer structure (7).

**7.** An arrangement according to one of claims 1-3, characterised in that the rf-SQUID magnetometer (2) comprises an rf-SQUID with double high gradiometer structure with opposite coils (9).

**8.** An arrangement according to one of the preceding claims, characterised in that the oscillating circuit (1) has a minimal resonance frequency of 400 MHz and a minimal quality of 1000.

**9.** An arrangement according to one of claims 1 to 8, characterised in that the rf-SQUID magnetometer (2) is coupled to a base plate (10).

**10.** An arrangement according to claim 9, characterised in that the oscillating circuit coil (1a) is configured as an internal loop surrounding the rf-SQUID magnetometer (2) and comprising a slot (4).

**11.** An arrangement according to claim 9 or 10, characterised in that the base plate (10) is configured as an external loop (10a) co-planar to the rf-SQUID magnetometer (2) and the oscillating tank circuit (1) and comprises a slot (11).

**12.** An arrangement according to claim 11, characterised in that the positioning of the slots (4; 11) of the interior loop (1a) and the exterior loop (11) in respect to each other determines the resonance frequency $f_r$.

**13.** An arrangement according to claim 12, characterised in that adjustment of the slots (4; 11) results in a change of the resonance frequency $f_r$ of < = 300 MHz.

## Revendications

**1.** Agencement pour coupler un magnétomètre rf-SQUID à un circuit oscillant supraconducteur de réservoir, caractérisé en ce que le circuit oscillant de réservoir (1) et le magnétomètre rf-SQUID (2) sont logés sur le même substrat de façon planaire l'un par rapport à l'autre, le circuit oscillant de réservoir (1) présentant une bobine de self-induction (1a) et une structure capacitive en deux dimensions qui entourent les magnétomètres rf-SQUID (2).

2. Agencement selon la revendication 1, caractérisé en ce que le circuit oscillant de réservoir (1) est à base de matériau supraconducteur à couche mince.

3. Agencement selon la revendication 1 ou 2, caractérisé en ce que le magnétomètre rf-SQUID (2) contient un rf-SQUID avec washer.

4. Agencement selon l'une quelconque des revendications 1 à 3, caractérisé en ce que le magnétomètre rf-SQUID (2) présente un rf-SQUID avec structure multiloop.

5. Agencement selon l'une quelconque des revendications 1 à 3, caractérisé en ce que le magnétomètre rf-SQUID (2) contient un rf-SQUID avec structure d'injection de courant (6).

6. Agencement selon l'une quelconque des revendications 1 à 3, caractérisé en ce que le magnétomètre rf-SQUID (2) contient un rf-SQUID avec structure de transformateur (7) multispire à couche unique ou multicouche.

7. Agencement selon l'une quelconque des revendications 1 à 3, caractérisé en ce que le magnétomètre rf-SQUID (2) présente un rf-SQUID avec structure de gradiomètre à double trou avec bobines en sens inverse (9).

8. Agencement selon l'une quelconque des revendications précédentes, caractérisé en ce que le circuit oscillant (1) présente une fréquence de résonance minimale de 400 Mhz et une qualité minimale de 1000.

9. Agencement selon l'une quelconque des revendications 1 à 8, caractérisé en ce que le magnétomètre rf-SQUID (2) est couplé à une plaque de base (10).

10. Agencement selon la revendication 9, caractérisé en ce que la bobine de self-induction (1a) est conçue comme une boucle interne qui entoure le magnétomètre rf-SQUID (2) et présente une fente (4).

11. Agencement selon la revendication 9 ou 10, caractérisé en ce que la plaque de base (10) est conçue comme une boucle externe (10a) coplanaire par rapport au magnétomètre rf-SQUID (2) et au circuit oscillant de réservoir (1) et présente une fente (11).

12. Agencement selon la revendication 11, caractérisé en ce que l'orientation des fentes (4; 11) de la boucle interne (1a) et de la boucle externe (11) les unes par rapport aux autres détermine la fréquence de résonance $f_r$.

13. Agencement selon la revendication 12, caractérisé en ce qu'un déplacement des fentes (4; 1) entraîne une modification de la fréquence de résonance fr d'une valeur $\leq$ 300 Mhz.

Fig.1

Fig. 2

C

1

2

3

1a

4

EP 0 890 113 B1

Fig. 3

Fig.4

C

Δ

L

$R_3$

$R_2$

$R_1$

1

2

4

EP 0 890 113 B1

Fig. 5a

EP 0 890 113 B1

Fig.5b

G

2

1

EP 0 890 113 B1

Fig. 5c

EP 0 890 113 B1

Fig. 5d

Fig. 5e

Fig. 6

Fig. 7a

Fig. 7b

Fig. 7c

_Fig. 8_

Flux rauschen [ $\phi_0$ / $\sqrt{Hz}$ ]

Frequenz [Hz]

Concentrator, SQUID#6, f=850MHz

$1.85 \cdot 10^{-5}$

$5.5.17 / \sqrt{Hz}$